(19)

Europäisches
Patentamt

European
Patent Office

Office européen
des brevets

(11) **EP 4 531 074 A1**

(12) **EUROPEAN PATENT APPLICATION**

(43) Date of publication:
02.04.2025 Bulletin 2025/14

(21) Application number: 23306644.8

(22) Date of filing: 29.09.2023

(51) International Patent Classification (IPC):
*H01J 37/32* (2006.01)    *F03H 1/00* (2006.01)
*H01J 37/34* (2006.01)    *H05H 1/54* (2006.01)

(52) Cooperative Patent Classification (CPC):
H01J 37/3444; H01J 37/32422; H01J 37/3464;
H01J 37/3467

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Centre National de la Recherche Scientifique
75016 Paris (FR)**
• **Université de Lorraine
54000 Nancy (FR)**

(72) Inventors:
• **CUYNET, Stéphane
54000 Nancy (FR)**
• **JEAN-MARIE-DÉSIRÉE, Ronny
54520 Laxou (FR)**
• **DE POUCQUES, Ludovic
54000 Nancy (FR)**

(74) Representative: **Office Freylinger**
**P.O. Box 48**
**8001 Strassen (LU)**

(54) **FAST HIGH VOLTAGE FOR IONIZATION IMPROVEMENT FOR SPUTTERING PROCESS**

(57)    The invention relates to a sputtering process of a target material in a vacuum environment comprising a sputtering target and plasmogenous process gas, wherein an electron accelerating pulse is applied to the sputtering target, whereby a high negative bias voltage is applied to the sputtering target during a period of time shorter than 1 microsecond, the bias voltage having an absolute value greater than 1 kV. This transitory regime of electron acceleration pulses is referred to as Fast High Voltage for Ionization Improvement (FHiVI[2]).

It can be operated alone or in combination with known sputtering processes, e.g. HiPIMS. The inventive process is suitable in sputtering deposition processes but also in other applications, e.g. for space propulsion.

Figure 1a

Figure 1b

Figure 1c

**EP 4 531 074 A1**

## Description

FIELD OF THE INVENTION

The present invention generally relates to the sputtering and ionization of elements, preferably metals or their compositions, by physical routes, e.g. physical vapor deposition or ion beam generation, and more specifically by cathodic sputtering.

BACKGROUND OF THE INVENTION

Deposition of thin films by physical vapor deposition (PVD) techniques has found widespread use in many industrial sectors. There is an increasing demand for coatings with tailored and enhanced properties such as high hardness, wear and corrosion resistance, low friction, and specific optical or electrical properties as well as decorative colors and often complex combinations of those properties are requested.

It is known (such as e.g. from WO2019234477 A1 or EP 4 143 360 A2) to implement machines able to carry out the coating of a substrate usually placed in a vacuum chamber, thanks to the deposition, on its surface, of atoms or ions emitted by a solid sacrificial body subjected to the bombardment of high energy particles. In particular, the emission of atoms or ions from the sacrificial body is caused by a plurality of high energy particles, such as for example gas ions in the plasma state, which is caused to hit the sacrificial body, therefore also termed "target". This deposition process is known as cathodic sputtering.

The target body can be composed of all the elemental materials or their compounds being deposited on the deposition substrate both in their pure and modified state by chemical reactions with the gases that are inside the vacuum chamber. In particular, during the erosion of the target body, the coating material, in the form of atoms, ions, or molecule portions, detaches from the latter and spreads in the surrounding areas, finally adhering on the deposition substrate.

The erosion of the target body can occur thanks to the use of an ionized gas, in the plasma state, interposed between said target body and said deposition substrate and suitably excited to provide high energy particles intended for hitting the target body in order to cause the afore said erosion thereof.

Machines and processes for the deposition of material by cathodic sputtering are known and have an electric potential difference between the target body and the deposition substrate. Usually, the target body is the cathode (the more negative pole) whereas the substrate, or another element, is the anode (the more positive pole).

The moment at which an inert gas, such as for example argon, is filled between said target body and said deposition substrate, in suitable pressure conditions (for example at 1 Pa), the free electrons in the gas are accelerated away from the cathode, the more negative charge, so that they hit the plasmogenous gas atoms and ionize them. In this way, a chain reaction is triggered and a partially ionized gas, or plasma, is achieved. The ionized atoms of the plasmogenous gas are in this case atoms with a positive charge and are thus accelerated by electrostatic attraction towards the cathode, in this case represented by the target body. The ionized atoms collide with the target surface, cause the detachment of coating material (atoms or ions) from the target that, by spreading in a direction opposite to the one taken by the target, is caused to adhere to the deposition substrate. The general physical mechanisms of the cathodic sputtering process which have just been described are valid for electropositive, electronegative, ion-ion plasmas and for all types of plasmogenous gas or gas mixture, whether reactive or not.

Improved machines and processes are known and further comprise a plurality of magnets (to form a so called "magnetron" thereby depositing material by magnetron sputtering), able to generate a magnetostatic field. Such magnets are usually placed under the target body, so that the resulting magnetic field interacts with the charged particles in the chamber, electrons in particular, interposed between the target body and the deposition substrate, increasing the probability of collisions with subsequent increase of the number of ionized molecules, in order to have higher process yield.

It has to be observed that by "yield" of the process the "sputtering yield" is usually meant, i.e. the ratio between the number of atoms eroded from the target and the incident ions on the surface of the target body.

In a cathodic sputtering process or a magnetron sputtering process, the ions available are mainly the ions of the plasmogenous sputtering gas and ions of the sputtered material are rare. A drawback is thus the low yield of the process, i.e. the low rate between the number of atoms eroded from the target and the ions hitting the surface of the target body, thus causing an increase of times and costs of the process.

High power impulse magnetron sputtering (Hi-PIMS) is a plasma-based modern physical vapor deposition (PVD) technique characterized by a very high peak power density ($>1$ kW/cm$^2$) at the sputtering target and a relatively high plasma density ($>10^{19}$ m$^{-3}$) in front of the target with short variable pulse durations (20-200 $\mu$s). This technique has been demonstrated to be useful for high-aspect-ratio filling applications and improved target utilization as well as enhancing substrate pre-treatment improving adhesion of hard coatings.

HiPIMS allows to achieve an increased ionization rate, however with some variability.

OBJECT OF THE INVENTION

It is thus an object of the invention to provide an improved sputtering technique, which allows increasing in the ionization rate of the sputtered species.

SUMMARY OF THE INVENTION

In order to achieve the above-mentioned object, the present invention proposes a sputtering process of a target material in a vacuum environment comprising a sputtering target and plasmogenous process gas, wherein an electron accelerating pulse is applied to the sputtering target, whereby a high negative bias voltage is applied to the sputtering target during a period of up to 1 microsecond, the bias voltage having an absolute value greater than 1 kV.

The invention hence essentially relies on the use of an ultra-fast high voltage pulse, leading to high intensity, referred to as electron accelerating pulse, designed to cause a sudden acceleration of the electrons in the gaseous plasma, by contrast to heavier species in the plasma (neutral elements, ions...) which will not be able to react on the corresponding time. In other words, due to the difference of electric potential and its very fast and short application time, it is possible to accelerate electrons - and electrons only. The other charged species (e.g. ions) will not be accelerated since they will not be sensitive to variations of the electric field that are this fast (of the order of MHz) and short (at the microsecond scale).

Due to its very short application time, the electron accelerating pulse can be referred to as transitory pulse. During a sputtering process, electron accelerating pulses are applied with given periodicity (fixed or varying frequency, depending on the application) and thus forms a transitory regime. In embodiments, the electron accelerating pulses may be applied as a sequence of pulses, referred to as burst pulses or burst mode. Such burst pulses may be repeated during the sputtering process. Implementing the inventive transitory regime of electron acceleration pulses in a plasma chamber may be referred to as Fast High Voltage for Ionization Improvement, in short FHiVI[2] (or FHiVII).

The inventive process is applicable in a vacuum environment, meaning in a vacuum that is maintained in any kind of reactor or chamber, but also in space vacuum.

The electron accelerating pulse may be generated by a power source configured to supply an output voltage of several kV or greater and with a fast rise time. Indeed, since the electron accelerating pulse has a duration up to 1 $\mu$s, the power supply must allow the voltage to rapidly increase to the target pulse value.

Preferably, the electron accelerating pulse is applied with a voltage rise time of at least 2 kV/ps. In particular, the rise time of the electron accelerating pulse may be higher than 5 kV/ps, preferably higher than 10 kV/ps, 20, 30 or 40 kV. Likewise, the decrease of voltage is preferably controlled with similar rates.

In embodiments, the electron accelerating pulse has transients voltages, with a voltage rising period up to the target voltage (i.e. at least 1 kV) followed by a voltage drop (or fall) period.

As used in the present text, the expression a 'negative bias voltage' as applied to the sputtering target means that the sputtering target is put at a lower potential than another reference potential, which may be e.g. the sample holder or the chamber walls. Stated otherwise, the difference of potential between the sputtering target and the reference potential is negative. There is no restriction on the polarity as long as the difference of potential is negative during sputtering phase of the process.

In embodiments, the electron accelerating pulse is operated with a negative bias having an absolute value higher than 1,5 kV, preferably higher than 2 kV and/or lower than 20 kV. That is, the negative voltage bias may be between -1 and -20 KV. It may be desirable to limit the negative bias voltage to a voltage having an absolute value lower than 20 kV in order to limit the production of X-rays and thus prevent an operator from being exposed to such rays.

The electron accelerating pulse is thus built as a pulse with high fast voltage, where the high negative bias voltage is applied to reach a target voltage on the target (i.e. difference of potential at the prescribed negative value). The period to reach the target voltage value from the start voltage (cathode voltage value at the moment the electron accelerating pulse is applied) may be referred to as rise period, or establishment time (the time to establish the desired bias voltage on the cathode/target). Conversely, the time period required for the voltage to decrease from the target value to the start voltage value is referred to as fall period. The time period during which the voltage is at the target voltage value is referred to as plateau; it may have a variable length, e.g. ranging from a few ns to a few 100s ns. The electron accelerating pulse thus consists of the rise period, the plateau and the fall period. The duration of the electron accelerating pulse corresponds to sum of these three periods and is 1 $\mu$s or less.

It is not particularly desired to reduce the duration of the electron accelerating pulse. It is rather a matter of ionic plasma oscillations pulsation duration and what matters is that the duration of one electron accelerating pulse does not exceed 1.0 $\mu$s in order to act on electrons and not affect ions. Hence in general, the electron accelerating pulse may have a duration of about 900 ns to 1 000 ns. However, for the sake of exemplification, the electron accelerating pulse preferably has a minimum duration of 400 ns.

In embodiments, the rise period and fall period may have similar lengths. The rise period, respectively the fall period, may represent up to 45 to 50% of the duration of the electron accelerating pulse, preferably it may represent 25, 20, 15 or 10% of the duration of the electron accelerating pulse. For example, where the rise and fall periods represent each 20%, the plateau (target voltage) may represent 60% of the pulse duration.

To recap, one of the merits of the invention is to have identified that such electrons accelerating pulses enable an increase of the number of ions resulting from the species/atoms sputtered from the target material with respect to non-ionized atoms sputtered from the target material. Indeed, accelerated electrons on a fast rise time hit species/atoms sputtered from the target material and present in the reactor, thereby ionizing the species/atoms and forming ionized species, or ions. Thenceforth, the energy and directionality of the ions may advantageously be controlled by applying a bias voltage to the substrate, or directly to the sputtering target (e.g. thanks to bi-polar regime).

Remarkably, the inventive process enables to significantly improve the ionization rate of the sputtered material (i.e. the number of ionized atoms sputtered from the target material with respect to non-ionized, neutral sputtered atoms) without requiring any additional device to be inserted into the reactor. This is of particular relevance as such additional devices (e.g. additional coils or magnets) are generally very disruptive and often cumbersome with respect to the sputtering process, such as but without being limited to a coating/deposition process. Additionally, it is currently believed that the inventive process may, under certain operating conditions, allow controlling the degree of ionization of the sputtered species.

Another merit of the invention is that it may be implemented with virtually all types of plasma-assisted processes, with numerous possible application fields, as it is independent of the target material to be sputtered as well as of the (inert or reactive) plasmogenous gas. The invention finds particular application in sputtering deposition processes, especially in combination with conventional sputtering deposition processes.

It will be appreciated that the inventors have surprisingly found that a successful implementation of the step of accelerating electrons (due to the (at least one) electron accelerating pulse) lies in the precise control of the difference of electric potential applied to the sputtering target. The FHiVI$^2$ regime relies on the use of fast, high voltage pulses, hence implementing a high rise time, which allows electrons to acquire a kinetic energy sufficient for leaving the vicinity of the sputtering target and participating efficiently in the ionization of sputtered target material (i.e. in the gas vapor).

A fine tuning, i.e. controlled modulation, of the bias voltage and its rise time on the target material allows controlling the ionization rate of the sputtered material (higher bias voltage and/or modulated duration of the step of accelerating electrons leading to higher ionization of sputtered material).

The FHiVI$^2$ regime hence proves very versatile, in that it allows a fine regulation of voltage, duration and application time, allowing, in fine, modulating or more generally controlling the ionization rate of the sputtered material in the gas phase.

Another merit of the present invention is that the implementation of the FHiVI$^2$ regime only requires the introduction, in the power circuit, therefore outside the reactor, of a power source with high frequency and very high voltage switching system with rise times in the order of megahertz. In other words, no structural modifications of a conventional sputtering chamber, a conventional cathode assembly and/or anode are required in order to perform the present inventive process. That is to say, the inventive process may easily be implemented on any kind of conventional sputtering device.

As indicated above, the FHiVI$^2$ regime is compatible with other plasma sputtering processes, namely known conventional sputtering processes. Such (conventional) plasma sputtering process may be used to initiate the discharge that will generate the plasma, respectively the vapour of target material, and hence start the sputtering process. Often, it is this other/conventional plasma sputtering process that is mainly used to control/sustain the sputtering process; it is therefore referred to as "reference sputtering process" in the following.

The electron accelerating pulses may thus be coupled to this reference sputtering process, being applied simultaneously (meaning applied or over-imposed at any moment during the reference sputtering process). This may be the case where the reference process is continuous or pulsed. Where the reference sputtering process is pulsed (reference cathode voltage pulses are applied, whereby a negative voltage is applied to the target), electron accelerating pulse(s) may be applied during a negative cathode voltage pulse, directly at the end of such pulse or thereafter.

Generally, the reference plasma process may be a process selected from direct current (DC) magnetron sputtering process, pulsed direct current (DC) magnetron sputtering process, radio frequency sputtering process (using RF or microwave sources), high power impulse magnetron sputtering process, or a combination thereof.

In embodiments, the method comprises the step of generating a static magnetic field in the vicinity of the target during sputtering, in order to increase plasma density and improve target erosion.

In general, the FHiVI$^2$ regime may be operated with a predetermined frequency, e.g. 1 to 250 kHz. That is, two consecutive electron accelerating steps should fall within the prescribed range, also in burst mode.

In embodiments, the reference sputtering process is a pulsed regime with frequency F1, such as e.g. HiPIMS or RF sputtering. The pulses of the FHiVI$^2$ regime may be applied at frequency F2 which is equal to F1. The same pulse pattern of pulses is thus repeated periodically. This is however only an example and other implementations can be envisaged. Additionally or alternatively, a plurality of electron accelerating pulses may be applied during a pulse of a reference sputtering process, i.e. bursts of electron accelerating pulses combined with a reference sputtering process.

In embodiments, a polarity inversion step (bipolar step) may be applied before and/or after the electron accelerating pulse, and possibly directly after.

It should however also be appreciated that,

alternatively, the FHiVI[2] regime can be implemented as a stand-alone regime, where bursts of electron accelerating pulses are applied to the target and will generate the plasma and subsequently provide the electron acceleration effect described above. This regime is referred to as 'autonomous burst mode'.

In burst mode, the electron accelerating pulses may be operated in sequences wherein the pulses are spaced by a predetermined time interval. In autonomous burst mode the electron accelerating pulses are not coupled with a reference plasma process.

As explained, the FHiVI[2] regime implies the implementation of electron accelerating steps, either as repeated, individual electron accelerating steps, or as bursts pulses (burst pulses may be combined with a reference sputtering process or as autonomous mode).

The electron accelerating pulses may be repeated in with regular or variable frequency. There is in general no specific limit on the number of repetitions and the repetition frequency, the electron accelerating pulses being however separated by more than 1 $\mu$s and preferably more than 2 or 3 $\mu$s.

Preferably, the repetition rate of electron accelerating pulses is no more than 250 kHz, in order to avoid potential boundary effects. This ensures a spacing of at least 4 $\mu$s between two consecutive electron accelerating pulses.

This is particularly desirable when operating burst pulses in combination with a pulsed mode reference puttering process.

One burst of pulses itself may comprise a few electron accelerating pulses, up to 100 pulses. For example, a set of 4, 5, 6, 7 or 8 pulses, or 10, 20, 30 or 50 pulses, or higher.

In embodiments, the vacuum chamber may comprise more than one sputtering target, and the electron accelerating pulses may be applied to one or more of the sputtering targets, as desirable.

The sputtering target may comprise one or more materials, e.g. any metal or compound, in particular metals, metallic alloys, metal oxides ceramics, polymers or combination thereof.

In embodiments, the target material is selected from the post-transition and transition metals groups notably comprising tungsten, aluminium, copper, nickel, titanium, platinum, palladium, silver and gold, their respective alloys, their respective hydrides, their respective oxides, their respective nitrides and the mixtures thereof. Carbon and some alkaline earth metals and metalloids as magnesium, calcium, boron and silicon are also considered as target material.

Any appropriate plasmogenous gas may be employed, e.g. selected from reactive and inert gases. The plasmogenous process gas may be pure or mixed.

In embodiments, the plasmogenous process gas is selected from the group comprising helium, neon, argon, krypton, xenon, hydrogen, nitrogen, oxygen, and mixtures thereof.

In embodiments, the present process, respectively the reference supporting processes, are operated to generate a cold plasma.

The inventive process is particularly adapted to be implement as sputtering process, wherein a negative bias voltage, referred to as reference cathode voltage, is applied to the sputtering target for a duration of more than 1 $\mu$s; and at least one electron accelerating pulse is applied during the reference process simultaneously. Here the FHiVI[2] regime is combined with a reference process. In case of DC regime, the electron accelerating pulses are applied over the reference cathode voltage. In case of pulsed sputtering process, the electron accelerating pulses may be applied during a reference cathode voltage pulse, or after (directly or with spacing).

During the reference plasma process the reference cathode voltage applied to the sputtering target may have an absolute value of no more than 2 kV or less than 1.5 kV or less than 1 KV. In case the reference cathode voltage is pulsed, the pulses have a duration that of at least 5, 10, 15 or 20 $\mu$s.

According to another aspect, the invention relates to a sputtering deposition process as claimed in claim 12.

According to still another aspect, the invention relates to method of generating a propulsion plasma according to claim 13. The FHiVI[2] regime is indeed also appropriate to improve ionization rate of a sputtering process implemented for spatial propulsion.

According to yet another aspect, the invention relates a method of generating an ion beam as claimed in claim 14.

According to yet another aspect, the invention relates a plasma sputtering device as claimed in claim 15.

Benefits of the inventive process may be summarized as follows:

- Any kind of plasma generating method may be used to generate a plasma;
- Any kind of material may be sputtered (no limitations regarding the nature of the target material);
- Any kind of plasmogenous gas may be used to generate a plasma;
- Easy implementation on already existing cathode sputtering devices;
- Improvement of the density (and possibly the degree) of ionization of species sputtered from the target material, without having to add coils around/ in the reactor (in case of plasma generation by radio frequency sputtering) or additional magnet (in case of plasma generation by magnetron sputtering);
- Regulation of the density of ionization of the sputtered material, e.g. via the difference of electric potential applied to the sputtering target during the step of accelerating electrons, its rise time, duration of its application and/or the number of repetitions of the step of accelerating electrons, e.g. via a burst mode;

- Applicable to any technical field associated with the use of a discharge regime in manufacturing processes: etching of cathode material, semiconductor doping, plasma assisted deposition/coating, plasma propulsion;
- Energy efficient process, faster deposition of target material, faster coating of substrates.

BRIEF DESCRIBTION OF THE DRAWINGS

The present invention will now be described, by way of example, with reference to the accompanying drawings, in which:

Fig. 1 is a principle drawing illustrating the principle of the process according to the invention;

Fig. 2 are graphs representing the voltage and current variations at the sputtering target as functions of time for a process according to the present invention and for a conventional process where a) represents whole sequence and b) is an enlarged view of the electron accelerating pulse;

Fig. 3 are graphs representing a) the voltage applied to the sputtering target being at the cathode, b) the current at the cathode and c) the resulting floating potential of the target as a function of time for a process according to the present invention and for a comparative process;

Fig. 4 is a mass spectrum plotting the intensity of tungsten ions ($W^+$) as a function of time for the inventive process and for a conventional process;

Fig. 5 a) is a graph representing the intensity of the emission line of ionized tungsten W II as a function of time for the inventive process and for a conventional process; and b) is a graph representing the respective intensities of the emission line of neutral tungsten W I and of the emission line of ionized tungsten W II as a function of time for the inventive process;

Fig. 6 is a graph representing the ratio of the respective intensities of the emission line of neutral tungsten W I and of the emission line of ionized tungsten W II as a function of the bias voltage applied during the electron accelerating pulse; and

Fig. 7 are graphs representing the voltage variations at the sputtering target as functions of time for other embodiments of the process according to the present invention.

DETAILED DESCRIPTION OF PREFERRED EMBODIMENTS

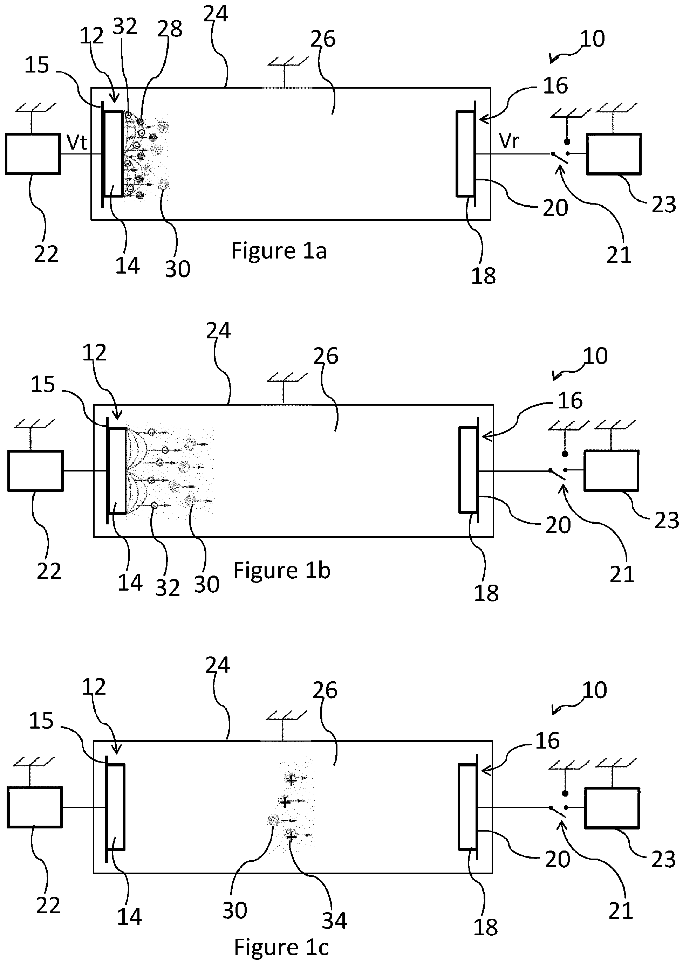

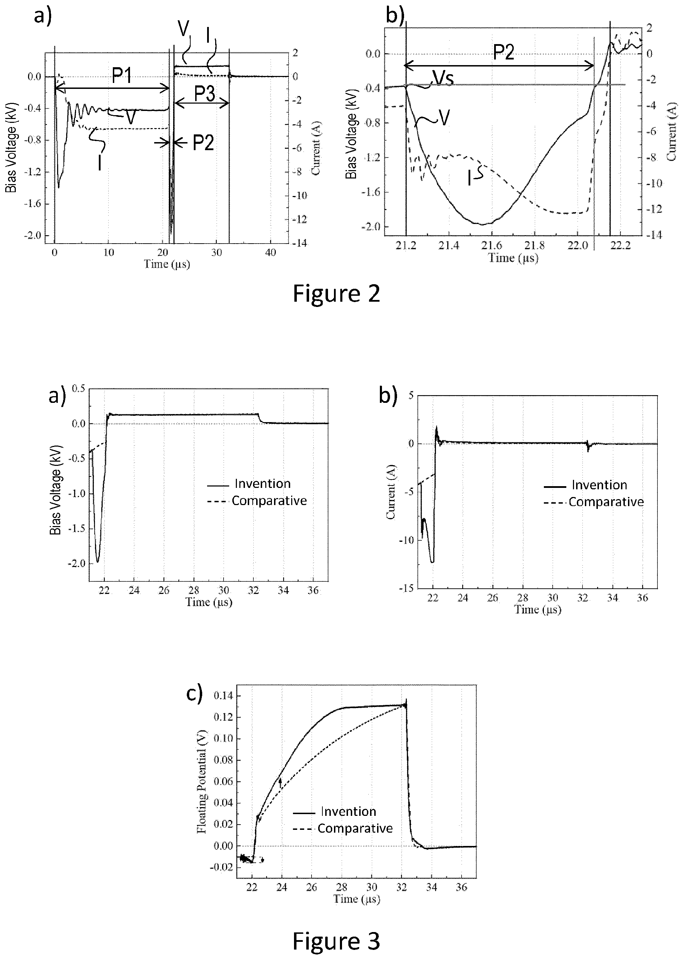

The inventive process will now be described with reference to Fig. 1 and Fig. 2, in an exemplary context of a HiPIMS deposition process.

A. The sputtering device

It may be noted that the inventive process may be implemented in a conventional sputtering device or system, such as a conventional cathodic sputtering device, which will therefore only be briefly described herein. In particular, it is not required to modify the (internal) structure of the process chamber (reactor).

As illustrated in Fig.1, a sputtering device 10 comprises a target assembly 12 and a substrate assembly 16 arranged inside a process chamber 24 (or reactor) that defines an enclosed volume 26.

The sputtering process is typically conducted at pressures lower than atmospheric (e.g. below 10 Pa), i.e. in a vacuum environment. The process chamber may thus be referred to as vacuum chamber.

In a sputtering deposition process the target assembly is often referred to as cathode, while the substrate assembly is the anode. The reactor walls may also be considered as anode if connected to the substrate holder.

The target assembly 12 typically comprises a sputtering target 14, which constitutes a solid material source. It Is received on a target holder 15, which forms the cathode electrode. The sputtering target 14 may consist of a single material or of a plurality of materials. The sputtering cathode may comprise any metal or compound, in particular metals, metallic alloys, metal oxides ceramics, polymers or combination thereof.

At the substrate assembly 16, a substrate 18, or deposition substrate, is arranged on a substrate holder 20 in front of the target assembly 12 and is spaced with respect to the same. The substrate holder 20 forms the anode electrode. Fig. 1 shows only one substrate 18, but there could be more on the holder 20. The substrate 18 can be any kind of element, part or components to be coated with target material ejected from the source.

A switch 21 allows connecting the substrate to ground, leaving the substrate disconnected at 'floating potential', or applying a bias voltage when connected to an auxiliary voltage supply 23. The skilled person may thus select between these options depending on the operating mode.

Reference sign 22 designates a power supply that is configurable to apply the energy needed to generate and sustain the plasma necessary for the sputtering process.

The power supply 22 may comprise direct current (DC) - pulsed (pulsed DC, HiPIMS, or not - and/or frequency power sources (radiofrequency or microwave frequency), depending on the application. The power supply 22 may further include controls to adjust the power levels, voltage, and current, as well as monitoring instruments to observe the process parameters and make adjustments, as needed.

In particular, the power supply 22 is configurable to operate according to the desired modes or regimes as described below, notably in the inventive FHiVI[2] regime.

In general, the power supply 22 is connected at one end to the target assembly 12 and at the other end to the substrate assembly 16 (as shown here) or to the walls of the reactor 24, in order to apply a predetermined bias voltage to the cathode. In the context of the invention, the power supply is dimensioned to operate at several kV. The potential of the target assembly 12 is noted Vt and the reference potential is noted $V_r$.

A source of plasmogenous gas (not shown) allows introducing plasmogenous gas into the volume 26 between the cathode assembly 12 and the substrate 18.

During the sputtering process, the plasmogenous gas will be ionized through application of high voltage. The ionized gas, placed at suitable pressure conditions (for example 1 Pa), forms the plasma that provides ion species that will hit and erode the sputtering target, thereby ejecting/dislodging atoms, or more generally 'sputtered species' from the target.

The sputtered species (often atoms and/or neutrally charged small clusters) may then travel across the vacuum chamber and deposit onto the substrate placed opposite the target. This deposition forms a thin film on the substrate surface.

The FHiVI[2] regime is a transitory regime using electron accelerating pulses which are designed as high voltage pulses -high negative bias greater than -1kV- of very short duration of less than (or up to) 1 microsecond. Such duration is considered appropriate for most cases, and can be shortened depending on the application. It is generally desirable that the duration of the electron accelerating pulse is shorter than ionic plasma oscillations for the respective species.

According to the equation of Langmuir waves, ionic plasma oscillations pulsation duration are defined as : $\frac{2\pi}{wp_i} = 2\pi\sqrt{\frac{m_i\varepsilon_0}{n\,e^2}}$ [s] ; with e the charge, $m_i$ the mass of the considered ions, $n$ the plasma density and $wp_i$ the ionic plasma oscillation.

For each electron accelerating pulses a high negative voltage bias is applied to the sputter target 14. That is the voltage is controlled by the power supply 22 to reach a predetermined voltage (i.e. at least -1 KV) within the duration of the pulse.

As used herein, the "high negative voltage bias" means that the difference of potential between the sputtering target, at potential Vt, and a reference at potential Vr, e.g. chamber walls and/ or the substrate, is negative: Vt-Vr <0.

This can be obtained when where both Vt and Vr are negative or positive, or where Vt is negative and Vr positive.

In practice, the negative voltage bias applied to the cathode may be of at least -1 kV, meaning -2 kV, or -5 kV, etc. For example, the negative voltage bias may be between -1 kV and -20 kV.

In the following, for ease of speech, the terms "rise time" or "increase" may be used to describe the voltage control by the power supply to operate the electron accelerating step, because the potential difference increases.

B. Example of sputter deposition process

Figs. 1 and 2 illustrate an embodiment of the inventive process, wherein the electron acceleration pulses are applied during a conventional HiPIMS deposition process (the reference sputtering process).

As will be known to those skilled in the art, HiPIMS is an advanced magnetron sputtering process. Therefore, magnetic element(s) (e.g. magnets or electromagnets, not shown) are arranged at the target assembly, spaced apart from the sputtering target material. The magnetic elements are configured to generate static magnetic fields that increase plasma density, maintain a stable and uniform plasma discharge, leading to improved target erosion and ultimately to consistent coating quality across the substrate at higher deposition rate (increased deposition/process yield).

The method starts with operating a reference sputtering process, here a HiPIMS mode (or regime), which will generate a plasma and start the sputtering and deposition process.

As conventionally known in the field, the HiPIMS regime involves applying high-energy pulses of power to the target material. During such pulses, a high voltage bias (the reference cathode voltage) is applied with very short variable pulse durations (e.g. 50 to 200 μs).

During this step, and represented in Fig. 1a, the plasma is generated after an electronic avalanche, leading to the ionization of the plasmogenous gas in the reactor, and the parallel production of electrons 32 in the gas. The plasmogenous gas ions 28 accelerated in the direction of the target 14 induce the sputtering of material of the target material, i.e. the sputtered species 30. The volume is thus enriched in species from the target and in electrons.

Turning to Fig.2 a), a HiPIMS pulse is indicated P1, which here is a voltage signal with a transient phase of several microseconds and then a plateau at about - 0.4 kV.

Next, the FHiVI[2] regime is coupled to the HiPIMS mode, by applying an electron accelerating pulse, noted P2, directly at the end of the HiPIMS pulse P1. In this embodiment, the electron accelerating pulse has a duration of less than 1 μs (about 950 ns) and a negative bias voltage of -2 kV is applied to the target.

The electron accelerating pulse is a transitory pulse, in that it has a very short duration, in particular compared to the HiPIMS pulses. It can be observed that the electron accelerating pulse here consists mainly of voltage transients. More specifically, the electron accelerating pulse structure consists of:

a rising period: the first portion (or rising edge) of the curve where the voltage increases negatively from the starting point Vs (voltage at the start of the electron accelerating pulse) down to the target value, i.e. here -2 kV;

a very short plateau where the voltage remains at the target, here less than about 100 ns; and

a fall period: the cathode voltage decreases from the plateau towards zero.

By definition, the duration of the pulse is measured from the moment the pulse is applied (with start voltage Vs being the cathode voltage at the moment the accelerating pulse is applied) until the voltage decreases from the plateau and reaches again the same value Vs.

It may be noted that whereas in this embodiment the FHiVI$^2$ pulse P2 is applied directed after the HiPIMS pulse P1, other configurations are possible. For example, pulse P2 may be performed (at least partially) simultaneously to step P1 or after a predetermined time after pulse P1. The voltage and duration of pulse P2 may be modulated depending on its time of application.

In the shown example, the difference of electric potential applied during the electron accelerating pulse is, compared to the HiPIMS pulse, quite high (fivefold the plateau of the HiPIMS pulse) and very rapid (the -2 kV target is reached in approximately 350 ns, i.e. with a rise speed $dV/dt$ of about 5.7 kV/$\mu$s). These temporal characteristics (e.g. rise time, fall time) of the difference of electric potential applied to the cathode/sputtering target provoke a sudden accelerations of the electrons in the volume with respect to the heavy species of the plasma (neutral elements, ions,...). In other words, due to the bias voltage of the electrons accelerating step and its very fast application time, i.e. rise time, it is possible to accelerate electrons 32 - and electrons only. The other charged species (e.g. ions) will not be accelerated since they will not be sensitive to variations of the electric field that are that fast (of the order of MHz) and of short duration (at the microsecond scale). The acceleration of the electrons is represented in Fig1 b).

The electrons 32 which have acquired a kinetic energy corresponding approximately to the difference of electric potential applied during the step of accelerating electrons then leave the vicinity of the cathode/sputtering target and are able to participate in the ionization of the material vaporized from the target material 14, i.e. the atoms 30 detached from the target material 14 by the hitting ions 28 from the plasma along their path toward to the substrate 18, thereby forming ions 34 (see Fig. 1c).

In this embodiment, the sputtering process comprises an additional step of applying a positive voltage bias to the cathode (or positive impulse), thereby performing a polarization inversion step. This is referred to as bipolar step. The bipolar step, P3 in Fig.2 b, starts directly at the end of step P2. The amplitude of the positive impulse, its duration and the moment of its application can be independently controlled. This results in the acceleration of the positively charged species (ions) towards the substrate.

### C. Further results

The graphs of Fig.2 have been obtained with a sputtering device as illustrated in Fig.1. The target material was tungsten and the target was spaced by 17.5 cm from the substrate. The working pressure in the chamber was 1 Pa. Pure argon was used as plasmogenous gas.

HiPIMS + bipolar pulse parameters: HiPIMS pulse of -400 V for 22 $\mu$s followed by a positive impulse of 150 V for about 10 $\mu$s. Pulse frequency 200 Hz.

FHiVI$^2$ pulse parameters: -2 kV pulse with a duration of 900 ns. Pulse frequency 200 Hz. The FHiVI$^2$ pulse is applied at the end of the HiPIMS pulse.

Contrary to the representation of Fig.1, the substrate is not grounded but left at floating potential.

The implementation of the electron accelerating pulse, resp. of the FHiVI$^2$ regime, in combination with the reference sputtering process (HiPIMS) induces notable modifications in the plasma present in the reactor, in particular on the directly measurable electrical characteristics thereof.

Fig.3 is illustrate plots of a) voltage, b) current and c) floating potential over time for the sputtering process with Fig.2 (i.e. with FHiVI$^2$) and b) for the reference process (HiPIMS+bipolar) alone.

The application of the electron acceleration pulse causes a sharp decrease of voltage, because of the additional difference of electric potential being applied to the sputtering target. The current measured at the cathode increases to reach a maximum value (in absolute value) of approximately 12 A in 0.8 $\mu$s whereas in the absence of an electron acceleration step, the current does not exceed, in absolute value, 5 A (Fig. 3b). This increase in current reflects an increase in the concentration of charged species, i.e. ions and electrons, at the cathode.

The potential at the substrate holder is left floating (i.e. not grounded); its evolution of thus dependent on the plasma itself (Fig.3c). When entering the bipolar step P3, the floating potential increases more rapidly for the process using FHiVI$^2$ than according to the reference method comprising only the HiPIMS discharge. This faster increase in the floating potential indicates that the ions flow gained in energy and/or that a higher quantity of positive charges (ions) in the reactor is also generated, i.e. the charges being generated during the electron acceleration step.

The faster variation of the floating potential observed with the FHiVI$^2$ regime highlights a modification of the plasma composition in the reactor in terms of charges and therefore of the concentration of ions over time, due to the application of an additional difference of electric potential (negative bias voltage of the electron accelerating pulse).

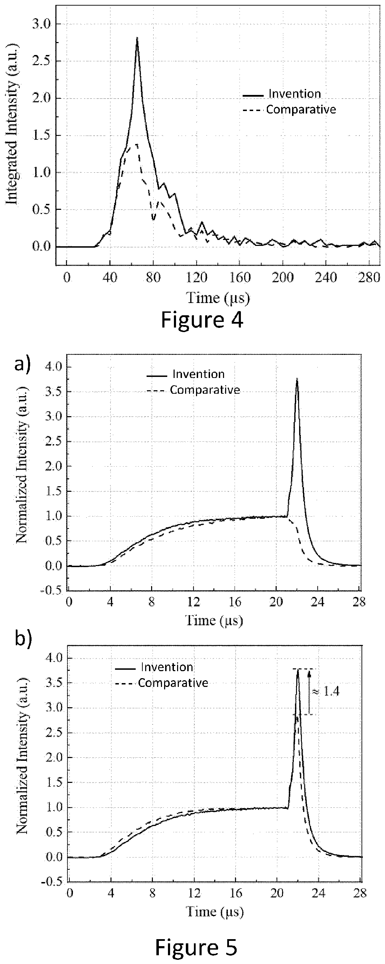

Time- and energy-resolved mass spectrometry measurements of the plasma in the reactor (Fig. 4) as well as optical emission spectroscopy measurements (Fig. 5a) also show an increase in signal intensity for the tungsten ions $W^+$, and therefore an increase in the concentration of tungsten ions $W^+$, when the sputtering process comprises an electron acceleration pulse as compared to a conventional HiPIMS process (i.e. without FHiVI[2]).

The optical emission spectroscopy measurements further indicate that the plasma obtained using the process according to the invention comprises approximately 1.4 times more tungsten ions $W^+$ (W II) than neutral tungsten W (W I) (Fig. 5b), in this specific case.

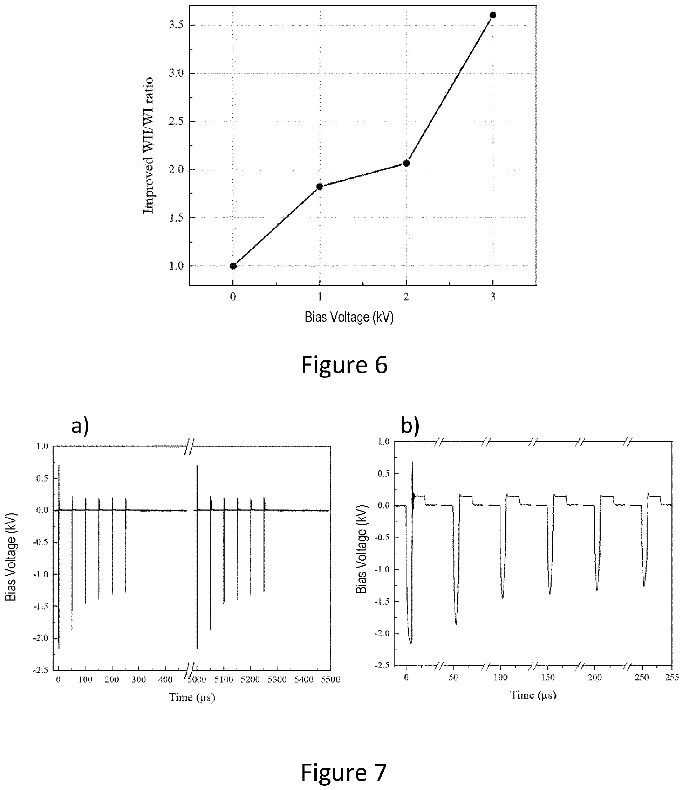

Further results were obtained by varying the absolute value of the bias voltage Vt applied to the sputtering target during the electron accelerating pulse (Fig. 6). The ratio of the respective intensities of the emission line of neutral tungsten W I and of the emission line of ionized tungsten W II increases with an increase (in absolute value) of the cathode bias voltage Vt.

D. Autonomous burst mode

As mentioned above, the inventive FHiVI[2] regime can be implemented as a stand-alone regime (i.e. without coupling to a reference sputtering process), in so-called "autonomous burst mode", where bursts of electron accelerating pulses are applied to the target and will generate the plasma and subsequently provide the electron acceleration effect described above. In general, series of pulses may each comprise 3 to 10, such as 2 to 8, e.g. 6, pulses with a frequency of 20 kHz and series may be repeated at a frequency of about e.g. 200 Hz.

An example of the FHiVI[2] regime operated in autonomous burst mode is shown in Fig. 7a: each burst comprises a set of 6 consecutive electron accelerating pulses with a frequency of 20 kHz (i.e. period of 50 $\mu$s) and the burst frequency is 200 kHz (i.e. the spacing between two consecutive bursts is 50 $\mu$s).

Another example is shown in Fig. 7b, where each electron accelerating pulse within the bursts is directly followed by a polarity inversion step. Alternatively, the polarity inversion steps (if any) may be applied solely for the last burst of the series.

**Claims**

1. A sputtering process of a target material in a vacuum environment comprising a sputtering target and plasmogenous process gas, **characterized in that** an electron accelerating pulse is applied to the sputtering target, whereby a high negative bias voltage is applied to the sputtering target during a period of time shorter than 1 microsecond, the bias voltage having an absolute value greater than 1 kV.

2. The sputtering process according to claim 1, wherein a voltage rise time of the electron accelerating pulse is higher than 2 kV/ps in absolute value.

3. The sputtering process according to claim 2, wherein the voltage rise time is higher than 5 kV/ps, preferably higher than 10 kV/ps.

4. The sputtering process according to claim 1, 2 or 3, wherein the negative bias voltage has an absolute value higher than 1,5 kV, preferably higher than 2 kV and/or lower than 20 kV.

5. The sputtering process according to any one of the preceding claims,
wherein an establishment time of the negative bias voltage represents up to 45 to 50% of the duration of the electron accelerating pulse, preferably 25, 20, 15, or 10%.

6. The sputtering process according to any one of the preceding claims, comprising performing a plurality of electron accelerating pulses at a predetermined frequency, which is no more than 250 kHz, in particular being applied as sequences of pulses.

7. The sputtering process according to any of claims 1 to 6, wherein
sequences of electron accelerating pulses are performed, the sequences being configured to generate a plasma, sustain the sputtering of target species and accelerate electrons.

8. The sputtering process according to any one of the preceding claims, wherein a polarity inversion step is applied before and/or after the electron accelerating step.

9. The sputtering process according to any one of the preceding claims,
wherein the plasmogenous process gas is selected from the group comprising helium, neon, argon, krypton, xenon, hydrogen, nitrogen, oxygen, and the mixture thereof.

10. The sputtering process according to any one of the preceding claims,

comprising operating a reference plasma process, by which a reference cathode voltage is applied to the sputtering target for a duration of more than 1 $\mu$s;

and applying at least one electron accelerating pulse a predetermined timings during the reference plasma process.

11. The sputtering process according to claim 10, wherein during the reference plasma process the reference cathode voltage applied to the sputtering target has an absolute value of no more than 2 kV and/or wherein the reference plasma process is operated as direct current magnetron sputtering process, pulsed direct current magnetron sputtering process, radio frequency sputtering process, high power impulse magnetron sputtering process, or a combination thereof.

12. A sputtering deposition process for depositing a layer of a target material onto a substrate in a reactor comprising a sputtering target and plasmogenous process gas, comprising:

    operating a reference sputtering process, whereby plasmogenous process gas is ionized and target material sputtered from the sputtering target and
    deposited onto the substrate; and
    applying one or more electron accelerating pulses as defined in any one of the preceding claims.

13. A method of generating a propulsion plasma using the sputtering process according to any one of claims 1 to 12.

14. A method of generating an ion beam using the sputtering process according to any one of claims 1 to 12.

15. A plasma sputtering device comprising a vacuum chamber comprising a sputtering target and connected to a source of plasmogenous gas, and a power supply, **characterized in that** the power supply comprises a power source configured to apply to the sputtering target electron accelerating pulses with a negative bias voltage of at least -1 kV and having a duration of no more than 1 $\mu$s.

Figure 1a

Figure 1b

Figure 1c

Figure 2

Figure 3

Figure 4

Figure 5

Figure 6

Figure 7

**Europäisches Patentamt**
**European Patent Office**
**Office européen des brevets**

# EUROPEAN SEARCH REPORT

**Application Number**

EP 23 30 6644

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/011737 A1 (WU JIN-YU [TW] ET AL) 20 January 2011 (2011-01-20) | 1-5, 8-12,15 | INV. H01J37/32 |
| Y | * abstract; claim 7; figures 2-5 * * paragraphs [0001], [0033] - [0057] * | 6,7,13, 14 | F03H1/00 H01J37/34 H05H1/54 |
| Y | US 2022/065234 A1 (BRENNING NILS [SE] ET AL) 3 March 2022 (2022-03-03) | 6,7,13, 14 | |
| A | * abstract; figures 1-4 * * paragraphs [0001], [0042] - [0087] * | 1-5, 8-12,15 | |
| A | US 2007/034498 A1 (GANCIU-PETCU MIHAI [RO] ET AL) 15 February 2007 (2007-02-15) * abstract; figures 1-3 * * paragraphs [0002], [0032] - [0034], [0055] - [0115] * | 1-15 | |
| A | US 2010/236919 A1 (ALAMI JONES [DE] ET AL) 23 September 2010 (2010-09-23) * abstract; claims 10,11; figures 4-6 * * paragraphs [0090] - [0098], [0112] * | 1-15 | |

| TECHNICAL FIELDS SEARCHED (IPC) |
|---|
| H01J H05H F03H |

The present search report has been drawn up for all claims

| Place of search | Date of completion of the search | Examiner |
|---|---|---|
| The Hague | 6 March 2024 | Remy, Jérôme |

EPO FORM 1503 03.82 (P04C01)

## ANNEX TO THE EUROPEAN SEARCH REPORT
## ON EUROPEAN PATENT APPLICATION NO.

EP 23 30 6644

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2024

| Patent document cited in search report | Publication date | Patent family member(s) | Publication date |
|---|---|---|---|
| US 2011011737 A1 | 20-01-2011 | NONE | |
| US 2022065234 A1 | 03-03-2022 | EP 3902999 A1 | 03-11-2021 |
| | | SE 1851669 A1 | 28-06-2020 |
| | | US 2022065234 A1 | 03-03-2022 |
| | | WO 2020139187 A1 | 02-07-2020 |
| | | WO 2020139188 A1 | 02-07-2020 |
| US 2007034498 A1 | 15-02-2007 | CN 1985022 A | 20-06-2007 |
| | | EP 1580298 A1 | 28-09-2005 |
| | | EP 1727924 A1 | 06-12-2006 |
| | | JP 2007529632 A | 25-10-2007 |
| | | KR 20070040747 A | 17-04-2007 |
| | | RU 2364661 C2 | 20-08-2009 |
| | | US 2007034498 A1 | 15-02-2007 |
| | | WO 2005090632 A1 | 29-09-2005 |
| US 2010236919 A1 | 23-09-2010 | AT E535629 T1 | 15-12-2011 |
| | | EP 2157205 A1 | 24-02-2010 |
| | | JP 6042048 B2 | 14-12-2016 |
| | | JP 2010031359 A | 12-02-2010 |
| | | JP 2015148015 A | 20-08-2015 |
| | | PL 2157205 T3 | 30-04-2012 |
| | | US 2010236919 A1 | 23-09-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019234477 A1

- EP 4143360 A2